# FASCICULE DE BREVET EUROPEEN

(11) **EP 4 222 811 B1**
(45) Date de publication et mention de la délivrance du brevet: **25.11.2026**
(21) Numéro de dépôt: 20838593.0
(22) Date de dépôt: 02.10.2020
(51) Int. Cl.: H01P 5/08, H01P 3/16, H01Q 13/08, H01P 1/208, H01P 5/107

(54) **CONNECTEUR RADIOFREQUENCE**
HOCHFREQUENZVERBINDER
RADIO FREQUENCY CONNECTOR

(43) Date de publication de la demande: 09.08.2023
(73) Titulaire: Centre National de la Recherche Scientifique, 75016 Paris (FR); STMicroelectronics France, 92120 Montrouge (FR); Institut Polytechnique de Bordeaux, 33402 Talence (FR); UNIVERSITE DE BORDEAUX, 33000 Bordeaux (FR)
(72) Inventeur: BERTHIER, Alexandre, 33000 BORDEAUX (FR); GHIOTTO, Anthony, 33130 BEGLES (FR); KERHERVE, Eric, 33600 PESSAC (FR); VOGT, Lionel, 73110 LA ROCHETTE (FR)
(74) Mandataire: Cabinet Beaumont
(86) Numéro de dépôt international: PCT/FR2020/051734
(87) Numéro de publication internationale: WO 2022/069806

(56) Documents cités:
- WO-A1-2019/133195
- DE-B3- 102019 118 733
- US-A1- 2016 036 114
- US-A1- 2017 059 356
- US-A1- 2019 013 563

## Description

### Domaine technique

La présente description concerne de façon générale les circuits électroniques, et plus particulièrement le domaine des transmissions de données par ondes radiofréquences.

### Technique antérieure

Les ondes radiofréquences ou ondes millimétriques dont la longueur d'onde est comprise par exemple entre 1 mm et 1 cm, permettent des transmissions de données à des débits relativement élevés. En outre, la plage des ondes radiofréquences présente des bandes non licenciées comme, par exemple, la bande 60 GHz, pour la transmission sans fil de données.

L'article "An 18Gbps Polymer Microwave Fiber (PMF) Communication Link in 40nm CMOS" de Niels Van Thienen et al., ESSCIRC Conference 2016: 42nd European Solid-State Circuits Conference, Lausanne, 2016, pp. 483-486, présente une transmission de données filaire, via une fibre polymère microonde. Plus particulièrement, la figure 7 de cet article, non reproduite ici, montre un dispositif comprenant une puce Rx/Tx d'émission/réception d'un signal radiofréquence, montée sur un guide d'onde intégré au substrat (SIW - "substrat integrated waveguide) d'une carte de circuit imprimé (PCB - "printed circuit board"). Le guide d'onde SIW est couplé à une antenne à fente conique de la carte de circuit imprimé, elle-même couplée à un guide d'onde plastique (PWG - "Plastic Waveguide"). Un boîtier métallique forme un bouclier autour de l'extrémité du guide d'onde SIW et de l'extrémité du guide d'onde plastique, et permet d'aligner les guides d'onde entre eux. Ce bouclier ne permet cependant pas de maintenir mécaniquement le guide d'onde SIW. L'ensemble de la carte PCB et du boîtier métallique constitue un connecteur radiofréquence, entre la puce Rx/Tx et le guide d'onde plastique.

Le connecteur radiofréquence décrit ci-dessus permet une liaison filaire pour transmettre des données sur une distance d'un ou plusieurs mètres au moyen d'ondes radiofréquences.

D'autres connecteurs radiofréquences entre une puce de circuits intégrés et un guide d'onde plastique, ou guide d'onde diélectrique (DWG - "dielectric waveguide"), adaptés aux ondes radiofréquences sont connus, comme par exemple US 2016/036114 A1, US 2019/013563 A1 ou DE 10 2019 118733 B3.

### Résumé de l'invention

Il existe un besoin de pallier tout ou partie des inconvénients des connecteurs radiofréquences connus.

En particulier, il serait par exemple souhaitable de disposer d'un connecteur radiofréquence qui permette non seulement une transmission filaire de données via un guide d'onde diélectrique ou plastique, mais également une transmission sans fil de données. Il serait alors par exemple souhaitable, que le connecteur permette une transmission sans fil de données dans la bande non licenciée des 60 GHz.

Un mode de réalisation pallie tout ou partie des inconvénients des connecteurs radiofréquences connus.

Par exemple, un mode de réalisation prévoit un connecteur radiofréquence permettant la mise en œuvre d'une transmission radiofréquence de données par une liaison filaire, via un guide d'onde plastique ou diélectrique, ou par une liaison sans fil, de préférence en se conformant aux normes d'émission radiofréquence en vigueur dans la bande d'émission radiofréquence considérée.

Un mode de réalisation prévoit un connecteur selon la revendication 1.

Selon un mode de réalisation, un diamètre de la troisième cavité est plus grand au niveau de ladite zone de couplage.

Selon un mode de réalisation, la première cavité est alignée longitudinalement avec une direction d'émission de l'antenne et la deuxième cavité est alignée longitudinalement avec l'extrémité du guide d'onde lorsque le guide d'onde et le deuxième boîtier sont assemblés, la deuxième cavité étant alignée longitudinalement avec la première cavité lorsque le deuxième boîtier est fixé de manière amovible au premier boîtier.

Selon un mode de réalisation, le guide d'onde est entouré d'une gaine en mousse en amont de ladite extrémité, le deuxième boîtier étant configuré pour enserrer la gaine du guide d'onde en exerçant une pression sur la gaine lorsque le guide d'onde et le deuxième boîtier sont assemblés, l'extrémité du guide d'onde étant dépourvue de gaine dans la deuxième cavité.

Selon un mode de réalisation, le deuxième boîtier comprend, du côté de la deuxième cavité opposée à la deuxième face, un anneau dont le diamètre interne est supérieur au diamètre du guide d'onde et inférieur au diamètre de ladite gaine, le deuxième boîtier étant configuré pour que la gaine soit en butée contre l'anneau lorsque le guide d'onde et le deuxième boîtier sont assemblés.

Selon un mode de réalisation, le deuxième boîtier est configuré pour que l'extrémité du guide d'onde affleure la deuxième face, ou soit en retrait de moins d'un millimètre par rapport à la deuxième face, lorsque le guide d'onde et le deuxième boîtier sont assemblés.

Selon un mode de réalisation, le deuxième boîtier comprend deux parties fixées l'une à l'autre, chacune des deux parties définissant une partie de la deuxième cavité, un plan de contact entre lesdites deux parties étant parallèle à une direction longitudinale de la deuxième cavité.

Selon un mode de réalisation, l'antenne est entièrement disposée dans la première cavité.

Selon un mode de réalisation, une puce de circuit intégré configuré pour recevoir un signal radiofréquence de l'antenne et/ou pour fournir un signal radiofréquence à l'antenne est destinée à être montée sur la carte de circuit imprimé, et une ligne de transmission radiofréquence de la carte de circuit imprimé est configurée pour coupler la puce montée sur la carte à l'antenne.

Selon un mode de réalisation, la ligne de transmission comprend un filtre radiofréquence passe-bande couplant la puce à l'antenne, le filtre étant de préférence un filtre intégré au substrat de la carte de circuit imprimé, ou un filtre rempli d'air intégré au substrat de la carte de circuit imprimé.

Selon un mode de réalisation, les premier et deuxième boîtiers sont configurés pour bloquer des ondes radiofréquences, les premier et deuxième boîtiers étant par exemple en un métal tel que de l'aluminium, en un alliage métallique tel qu'un alliage métallique comprenant de l'aluminium, en un plastique revêtu d'un métal tel que de l'aluminium, ou en un plastique revêtu d'un alliage métallique tel qu'un alliage métallique comprenant de l'aluminium.

Selon un mode de réalisation, le connecteur est configuré pour des transmissions radiofréquences à 60 GHz.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A à 1C illustrent une première partie d'un connecteur radiofréquence selon un mode de réalisation ;
les figures 2A à 2D illustrent une deuxième partie amovible du connecteur des figures 1A à 1C selon un mode de réalisation ;
la figure 3 illustre de manière plus détaillée une partie du connecteur des figures 1A à 1C et 2A à 2D ; et
les figures 4A et 4B illustrent le connecteur des figures 1A à 1C et 2A à 2D lorsque la deuxième partie amovible du connecteur est attachée à la première partie du connecteur.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications usuelles dans lesquelles peuvent être mises en œuvre des transmissions radiofréquences de données, filaires ou sans fil, n'ont pas été détaillées, les modes de réalisation décrits étant compatibles avec ces applications usuelles.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Les inventeurs proposent ici un connecteur radiofréquence configurable mécaniquement entre une configuration pour la transmission radiofréquence sans fil de données et une configuration pour la transmission radiofréquence filaire de données, via un guide d'onde plastique ou diélectrique dans ce dernier cas. Le connecteur proposé comprend une première partie comprenant un boîtier et une carte de circuit imprimé munie d'une antenne radiofréquence, et une deuxième partie amovible comprenant un autre boîtier dans lequel est maintenu en place un guide d'onde plastique ou diélectrique. Lorsque le boîtier de la deuxième partie amovible est attaché, ou fixé ou assemblé ou monté, de manière amovible au boîtier de la première partie du connecteur, le connecteur permet une transmission filaire de données. En outre, lorsque la deuxième partie amovible est détachée de la première partie du connecteur, le connecteur est adapté à une transmission sans fil de données, de préférence, en respectant les normes d'émission radiofréquence en vigueur dans la bande d'émission considérée.

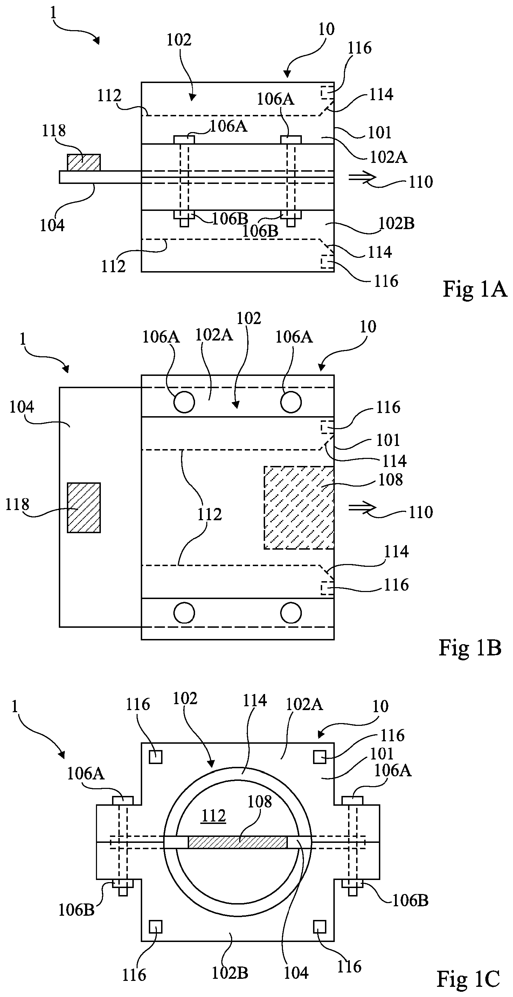

Les figures 1A, 1B et 1C illustrent, de manière schématique, une première partie 10 d'un tel connecteur radiofréquence 1 selon un mode de réalisation.

Plus particulièrement, la figure 1A est une vue de côté de la partie 10 du connecteur 1, la figure 1B est une vue de dessus de la partie 10 du connecteur 1 et la figure 1C est une vue de face de la partie 10 du connecteur 1, c'est-à-dire une vue d'une face 101 de la partie 10 du connecteur 1 destinée à coopérer avec une face d'une deuxième partie amovible (non représentée) du connecteur 1. Dans les figures 1A à 1C, le connecteur 1 est dans une configuration de transmission radiofréquence sans fil de données, et la deuxième partie amovible du connecteur 1 n'est donc pas attachée à la partie 10 du connecteur 1.

La partie 10 du connecteur 1 comprend un boîtier 102 et une carte de circuit imprimé 104. Le boîtier 102 est assemblé avec la carte 104.

A titre d'exemple, comme cela est représenté en figures 1A, 1B et 1C, le boîtier 102 comprend deux parties 102A et 102B disposées de part et d'autre de la carte 104, les parties 102A et 102B étant maintenues solidaires, ou fixées, l'une avec l'autre. La partie supérieure 102A du boîtier 102 repose en partie sur une face supérieure de la carte 104 et la carte 104 repose en partie sur la partie inférieure 102B du boîtier 102, de sorte que les deux parties 102A et 102B prennent la carte 104 en sandwich et la maintiennent en place dans le boîtier 102.

A titre d'exemple, les parties 102A et 102B du boîtier 102 sont fixées l'une à l'autre par des éléments de fixation, par exemple des ensembles d'une vis 106A et d'un écrou 106B bien que les parties 102A et 102B puissent également être collées l'une à l'autre par de la colle ou fixées l'une à l'autres par tout autre moyen adapté connu de la personne du métier. A titre d'exemple, dans le cas où les parties 102A et 102B sont collées l'une à l'autre, des dispositifs d'alignement, par exemple des ergots d'alignement, peuvent être prévus.

Selon un mode de réalisation, les vis 106A traversent la carte 104 ce qui permet d'améliorer le maintien mécanique de la carte 104 dans le boîtier 102.

Selon un mode de réalisation, comme cela se voit notamment en figure 1C, le boîtier 102, c'est-à-dire chacune des parties 102A et 102B qui le composent dans cet exemple, peut être plus mince aux emplacements où les vis 106A traversent le boîtier 102.

Dans un autre exemple non représenté, le boîtier 102 peut être réalisé d'une seule pièce, par exemple par un procédé de moulage. Le boîtier 102 comprend alors, par exemple, une fente dans laquelle peut être insérée la carte 104, des éléments de fixation tels que de la colle ou les vis 106A et les écrous 106B permettant alors de fixer la carte 104 au boîtier 102.

La carte 104 comprend une antenne radiofréquence 108 (hachurée en trait pointillé en figure 1B et hachurée en figure 1C).

Dans l'exemple de mode de réalisation illustré, l'antenne 108 est configurée pour émettre un champ radiofréquence dans une direction 110 parallèle aux faces principales (supérieures et inférieures) de la carte 104, l'antenne 108 est alors disposée le long d'un bord de la carte 104.

A titre d'exemple, l'antenne 108 est une antenne antipodale à fente linéaire conique ("Antipodal Linear Tapered Slot Antenna") ou antenne ALTSA bien connue de la personne du métier. L'antenne 108 peut également être une antenne Vivaldi.

Selon un mode de réalisation, le boîtier 102 définit ou comprend une cavité 112 (en trait en pointillé en figures 1A et 1B) de section transversale circulaire, par exemple une cavité cylindrique, autour de l'antenne 108. Dit autrement, l'antenne 108 est disposée, de préférence entièrement, dans la cavité 112. La cavité 112 est remplie d'air autour de l'antenne 108.

La cavité d'air 112 débouche sur la face 101 du boîtier 102, c'est-à-dire la face 101 destinée à coopérer avec une face de la partie amovible du connecteur 1 dans une configuration de transmission filaire. En outre, la cavité 112 est alignée longitudinalement avec la direction 110 d'émission de l'antenne 108, de sorte que le champ émis par l'antenne sorte de la cavité 112 au niveau de la face 101, de manière sensiblement orthogonale à cette face 101. L'antenne 108 est alors disposée du côté de la face 101. A titre d'exemple, un bord de la carte 104 disposée du côté de la face 101 affleure la face 101, ou est en léger retrait, par exemple de moins d'un millimètre, voire moins d'un demi millimètre, par rapport à la face 101.

La paroi de la cavité 112 est configurée pour bloquer les ondes radiofréquences, ou, dit autrement, la paroi de la cavité 112 est un écran pour les ondes radiofréquences. Cela permet d'éviter que le champ rayonné par l'antenne 108 dans des directions autres que la direction 110 ne perturbent l'environnement du connecteur 1. Dit autrement, la paroi de la cavité 112 participe à améliorer la directivité d'émission de l'antenne. Dit encore autrement, la paroi de la cavité 112 participe à augmenter le gain d'antenne par rapport au cas où le boitier 102 serait absent. La paroi de la cavité 112 permet aussi que des ondes radiofréquences provenant de l'environnement du connecteur 1 ne perturbent l'antenne 108.

La paroi de la cavité 112 est, par exemple, en un matériau configuré pour bloquer (réfléchir) les ondes radiofréquences, par exemple en un métal tel que l'aluminium ou en un alliage métallique tel qu'un alliage métallique à base d'aluminium. Plus généralement, ce matériau peut être n'importe quel matériau métallique à forte conductivité électrique, c'est-à-dire une conductivité électrique par exemple supérieure à 5x10E6 S/m, par exemple de l'argent, du cuivre, du fer, de l'or, du nickel ou un alliage de ces métaux. Toutefois, l'aluminium est préféré car il est peu couteux, facile à usiner et léger. A titre d'exemple, le boîtier 102 est entièrement en ce matériau bloquant les ondes radiofréquences ou est en plastique revêtu de ce matériau, par exemple en plastique métallisé, au moins sur la paroi de la cavité 112, ou est en plastique chargé d'un matériau métallique à forte conductivité électrique. Le diamètre de la cavité 112 autour de l'antenne 108 est par exemple choisi pour améliorer le gain d'antenne par rapport au cas où l'antenne 108 ne serait pas disposée dans la cavité 112, c'est-à-dire par rapport au cas où le boitier 102 serait omis. En effet, la cavité 112 agit alors comme un guide d'onde circulaire permettant de guider le champ émis par l'antenne. Toutefois, afin de ne pas perturber l'antenne 108, le diamètre de la cavité est par exemple choisi suffisamment grand, par exemple supérieur à la largeur de l'antenne 108.

Le diamètre de la cavité 112 augmente en se rapprochant de la face 101. Cela permet, comme on le verra plus tard, une diminution, voire une suppression, des perturbations, par des éléments du connecteur 1, du couplage de l'antenne 108 au guide d'onde de la partie amovible du connecteur 1 dans une configuration de transmission radiofréquence filaire. La cavité 112 présente un chanfrein 114 du côté de la face 101.

Le boîtier 102 comprend des éléments 116 de fixation amovible, configurés pour permettre une fixation amovible de la deuxième partie du connecteur 1 à la partie 10 du connecteur 1. Ces éléments de fixation sont par exemple destinés à coopérer avec des éléments de fixation amovible correspondants de la partie amovible du connecteur 1.

Dans l'exemple représenté, le boîtier 102 comprend des aimants 116 du côté de la face 101, les aimants 116 affleurant par exemple la face 101. Dans un autre exemple non illustré, le boîtier 102 comprend des trous traversant le boîtier 102 perpendiculairement à la face 101, de manière à y insérer des vis pour pouvoir fixer de manière amovible les deux parties du connecteur 1 entre elles. La personne du métier est en mesure de mettre en œuvre d'autres moyens connus de fixation amovible.

La carte 104 est destinée à être assemblée avec une puce de circuits intégrés 118 configurée pour recevoir un signal radiofréquence en provenance de l'antenne 108 et/ou pour fournir un signal radiofréquence à émettre à l'antenne 108. En figures 1A et 1B, la puce 118 est représentée montée sur la carte 104.

La puce 118 est couplée à l'antenne 108. Ainsi, bien que cela ne soit pas représenté en figures 1A, 1B et 1C, la carte 104 comprend une ligne de transmission radiofréquence couplant la puce 118 à l'antenne 108. Cette ligne de transmission est, par exemple, une ligne microruban, un guide d'onde SIW ou un ensemble d'une ligne microruban et d'un guide d'onde SIW. Cette ligne de transmission peut également être une ligne coplanaire ou une ligne de type "stripline" (triplaque). Selon un mode de réalisation, la puce 118 est montée directement sur la ligne de transmission, par exemple par soudure ou brasure, ce qui permet de réduire les pertes. A titre d'exemple, la puce 118 comprend une matrice de billes conductrices ("ball grid array") ou BGA permettant de monter, par exemple par soudure ou brasure, la puce 118 directement sur la ligne de transmission.

Selon un mode de réalisation, la ligne de transmission est couplée à l'antenne 108 par l'intermédiaire d'un filtre radiofréquence passe bande (non représenté), par exemple centré sur la fréquence de fonctionnement du connecteur. Dit autrement, la ligne de transmission de la carte 104 comprend un filtre couplant l'antenne 108 et la puce 118. Le filtre permet, par exemple, que la puissance radiofréquence émise par l'antenne 108 soit bien comprise dans une gamme désirée de fréquences. A titre d'exemple, lorsque le connecteur est configuré pour fonctionner à 60 GHz, le filtre peut être configuré pour que, en configuration de transmission sans fil, 99% de la puissance du champ émis par l'antenne 108 soit compris dans la gamme de fréquences allant de 57 GHz à 64 GHz, conformément à la spécification ETSI EN 305550. La mise en œuvre d'un tel filtre est à la portée de la personne du métier.

Selon un mode de réalisation, la ligne de transmission comprend un guide d'onde SIW, et le filtre est réalisé dans ce guide d'onde SIW, ou, dit autrement, est intégré au guide d'onde SIW de la ligne de transmission. Par rapport au cas où le filtre serait un composant monté sur la carte 104, cela permet de limiter les pertes et de réduire l'encombrement du connecteur 1. La réalisation de ce filtre intégré au guide d'onde SIW est à la portée de la personne du métier. La réalisation du filtre dans un guide d'onde SIW permet de tirer profit du fait qu'il suffit simplement d'ajouter des vias au guide d'onde SIW existant, ce qui augmente peu ou pas la surface du guide d'onde SIW, ce dernier étant présent pour fournir un signal radiofréquence à l'antenne ou pour recevoir un signal radiofréquence de l'antenne 108.

Dans l'exemple de mode de réalisation décrit ici où la direction 110 d'émission de l'antenne 108 est parallèle à la carte 104, le filtre est par exemple au moins en partie, de préférence entièrement, disposé dans la cavité 112 pour limiter les perturbations radiofréquences provenant de l'extérieur du connecteur 1, par exemple des perturbations radiofréquences de l'antenne 108 étant donné que le guide d'onde SIW précède directement l'antenne.

En configuration de transmission radiofréquence sans fil, le connecteur 1 ne comprend que la partie 10 décrite ci-dessus et l'antenne 108 émet alors un champ radiofréquence dans la direction 110 ou reçoit un champ radiofréquence dans une direction opposée à la direction 110. Une telle liaison sans fil est particulièrement adaptée pour des transmissions de données sur des distances relativement courtes par rapport aux distances de transmission pouvant être atteintes dans une transmission filaire.

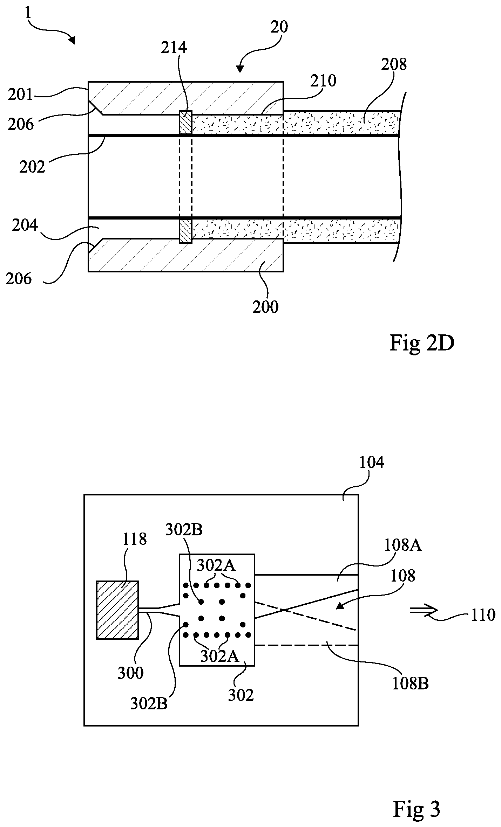

La figure 3 représente une vue de dessus schématique plus détaillée de la carte 104 selon un exemple de mode de réalisation.

Dans ce mode de réalisation, la ligne de transmission couplant la puce 118 à l'antenne 108 comprend une ligne microruban 300 et un guide d'onde SIW 302. La puce 118 est soudée directement sur la ligne microruban 300, et le guide d'onde 302 couple la ligne 300 à l'antenne 108. De manière classique pour la personne du métier, la ligne microruban 300 s'élargit en se rapprochant du guide d'onde 302, de manière à mettre en œuvre une transition entre la ligne microruban 300 et le guide d'onde 302.

Le guide d'onde 302 comprend deux plaques métalliques définies dans deux niveaux différents de métal de la carte PCB 104. Deux successions de vias 302A alignés reliant les plaques métalliques entre elles forment deux murs parallèles définissant les bords latéraux du guide d'onde 302, les bords supérieur et inférieur du guide d'onde 302 étant définis par les deux plaques métalliques.

Dans ce mode de réalisation, la ligne de transmission comprend un filtre passe bande, intégré au guide d'onde 302. Le filtre est réalisé par des vias inductifs 302B reliant les plaques métalliques entre elles. Les vias 302B sont disposés entre les murs formés par les vias 302A et forment des cavités résonnantes. La mise en œuvre d'un tel filtre est à la portée de la personne du métier.

Dans ce mode de réalisation, l'antenne 108 est une antenne ALTSA. L'antenne comprend alors deux portions 108A et 108B de plaques métalliques disposées dans deux niveaux différents de métal de la carte PCB 104, la portion 108B (normalement non visible en figure 3) étant représentée par des traits en pointillé. Par exemple, les deux portions 108A et 108B sont définies dans les mêmes niveaux de métal que les plaques métalliques du guide d'onde 302. La largeur de chacune de ces portions 108A et 108B décroit linéairement dans la direction 110 d'émission de l'antenne 108. La réalisation d'une telle antenne est à la portée de la personne du métier.

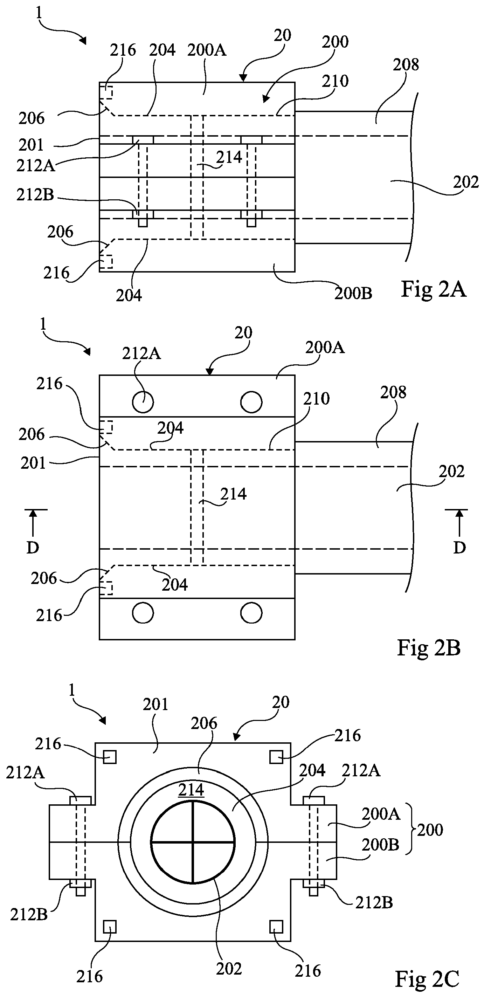

Les figures 2A à 2D illustrent une partie amovible 20 du connecteur 1 des figures 1A à 1C selon un mode de réalisation. Plus particulièrement, la figure 2A est une vue de côté de cette partie 20 du connecteur 1, la figure 2B est une vue de dessus de la partie amovible 20 du connecteur 1, la figure 2C est une vue de face de la partie 20 du connecteur 1, c'est-à-dire une vue d'une face 201 de la partie 20 du connecteur 1 destinée à coopérer avec la face 101 de la partie 10 du connecteur 1 (figures 1A, 1B et 1C), et la figure 2D est une vue en coupe prise dans le plan DD de la figure 2B.

La partie amovible 20 du connecteur 1 comprend un boîtier 200 configuré pour être assemblé avec un guide d'onde diélectrique ou plastique 202 ayant une section transversale circulaire. En figures 2A à 2D, le boîtier 200 et le guide d'onde 202 sont représentés assemblés l'un avec l'autre. Dans cet exemple, comme cela est illustré en figure 2C, le guide d'onde 202 est du type décrit dans la demande de brevet WO 2017191409, et comprend donc un tube en PTFE, par exemple en le matériau désigné par l'appellation commerciale Teflon, muni d'une croix à deux bras orthogonaux en PTFE, par exemple en Teflon, disposée dans le tube.

Selon un mode de réalisation, le boîtier 200 définit, ou comprend, une cavité 204 (en trait en pointillé en figures 1A et 1B) de section transversale circulaire, par exemple une cavité cylindrique, autour d'une extrémité du guide d'onde 202, et, plus exactement, autour de l'extrémité du guide d'onde 202 destinée à être couplée à l'antenne 108 (figures 1A, 1B et 1C) dans une configuration de transmission filaire. Par extrémité de guide d'onde, on entend ici une portion longitudinale du guide d'onde 202 s'étendant jusqu'à une extrémité ou une fin du guide d'onde. Le diamètre de la cavité 204 est supérieur au diamètre (externe) du guide d'onde 202, de sorte que, autour de l'extrémité du guide d'onde 202, la cavité 204 est remplie d'air.

La cavité 204 débouche sur la face 201 du boîtier 200, c'est-à-dire la face 201 destinée à, ou configurée pour, coopérer avec la face 101 de la partie 10 du connecteur 1 (figures 1A, 1B et 1C) dans une configuration de transmission filaire. En outre, la cavité 204 est alignée longitudinalement avec la direction longitudinale du guide d'onde 202, de sorte qu'une section transversale exposée du guide d'onde 202 soit en regard de l'antenne 108, et soit disposée perpendiculairement à la direction 110 (figures 1A et 1B), dans une configuration de transmission filaire. Comme cela est représenté en figures 2A à 2D, le boîtier 200 est de préférence configuré pour que l'extrémité du guide d'onde 202 affleure la face 201, ou soit en léger retrait, par exemple de moins d'un millimètre, de préférence de moins d'un millimètre, par rapport à la face 201.

La paroi de la cavité 204 est configurée pour bloquer les ondes radiofréquences. Cela permet d'éviter que, dans une configuration de transmission filaire, le couplage entre l'antenne 108 et le guide d'onde 202 ne soit perturbé par des ondes radiofréquences en provenance de l'environnement du connecteur 1. Pour cela, la paroi de la cavité 204 est en un matériau configuré pour bloquer les ondes radiofréquences, par exemple en un métal tel que l'aluminium ou en un alliage métallique tel qu'un alliage métallique à base d'aluminium. Plus généralement, ce matériau configuré pour bloquer les ondes radiofréquence peut être l'un des matériaux configurés pour bloquer les ondes radiofréquences donnés à titre d'exemple en relation avec les figures 1A à 1C.

A titre d'exemple, le boîtier 200 est entièrement en ce matériau configuré pour bloquer les ondes radiofréquences, ou est en plastique revêtu de ce matériau, au moins sur la paroi de la cavité 204.

Le diamètre de la cavité 204 augmente en se rapprochant de la face 201. Cela permet, comme on le verra plus tard, une diminution, voire une suppression, des perturbations, par les éléments du connecteur 1, du couplage de l'antenne 108 au guide d'onde 202 dans une configuration de transmission filaire. La cavité 204 présente un chanfrein 206 du côté de la face 201.

Le boîtier 200 est configuré pour maintenir en place le guide d'onde 202.

Dans le mode de réalisation illustré, le guide d'onde 202 est entouré, en amont de l'extrémité du guide d'onde 202 disposée dans la cavité 204, par une gaine en mousse 208, par exemple une mousse en PTFE telle qu'une mousse en Teflon. Pour maintenir en place le guide d'onde 202, le boîtier 200 est alors configuré pour enserrer une partie du guide d'onde 202 revêtu de la gaine 208, en exerçant une pression sur la gaine 208.

A titre d'exemple de mode de réalisation, comme cela est représenté en figures 2A, 2B et 2D, la cavité 204 se prolonge, du côté opposé à la face 201, par une cavité 210 de section transversale circulaire, par exemple une cavité 210 cylindrique, dont le diamètre est inférieur au diamètre externe de la gaine 208. Ainsi, quand une portion longitudinale du guide d'onde 202 revêtue de la gaine 208 est insérée dans la cavité 210, le boîtier 200 enserre la gaine 208 et exerce une pression sur la gaine 208, ce qui permet de maintenir le guide d'onde 202 dans le boîtier 200. Comme cela est représenté sur les figures 2A à 2D, les cavités 204 et 210 peuvent avoir le même diamètre. En outre, dans cet exemple l'ensemble des cavités 204 et 210 forment une ouverture traversant le boîtier 200 de part en part, dans une direction orthogonale à la face 201.

Dans l'exemple illustré par les figures 2A à 2D, le boîtier 200 comprend deux parties 200A et 200B disposées de part et d'autre du guide d'onde 202, les parties 200A et 200B étant maintenues solidaires, ou fixées, l'une avec l'autre. Chacune des deux parties 200A et 200B définit une partie de la cavité 204, et, dans cet exemple de la cavité 210. Les deux parties 200A et 200B sont en contact l'une avec l'autre, par exemple, au niveau d'un plan de contact parallèle à la direction longitudinale de la cavité 204. Les deux parties 200A et 200B enserrent la gaine 208 du guide d'onde 202 au niveau de la cavité 210, ce qui permet le maintien mécanique du guide d'onde 202 dans le boîtier 200.

A titre d'exemple, les parties 200A et 200B du boîtier 200 sont fixées l'une à l'autre par des éléments de fixation, par exemple des ensembles d'une vis 212A et d'un écrou 212B bien que les parties 200A et 200B puissent également être collées l'une à l'autre ou fixées l'une à l'autre par tout autre moyen adapté connu de la personne du métier.

Selon un mode de réalisation, comme cela se voit notamment en figure 2C, le boîtier 200, c'est-à-dire chacune des parties 200A et 200B qui le composent dans cet exemple, peut être plus mince aux emplacements où les vis 212A traversent le boîtier 200.

Dans un autre exemple non représenté, le boîtier 200 peut être réalisé d'une seule pièce. Le guide d'onde 202 est alors inséré en force dans les cavités 204 et 210.

En outre, dans le cas où le guide d'onde 202 est revêtue de la gaine 208 en mousse en amont de l'extrémité de ce dernier qui est disposée dans la cavité 204, selon un mode de réalisation, le boîtier 200 comprend, du côté de la cavité 204 opposé à la face 201, un dispositif de butée pour la gaine 208, de sorte que lorsque l'extrémité du guide d'onde 202 qui n'est pas revêtue de la gaine 208 est disposée dans la cavité 204, la gaine 208 vient faire contact contre le dispositif de butée.

Plus particulièrement, selon un exemple de mode de réalisation, le boîtier 200 comprend un anneau 214 du côté de la cavité 204 opposée à la face 201. L'anneau 214 est disposé perpendiculairement à la direction longitudinale de la cavité 204. L'anneau 214 forme alors le fond de la cavité 204, du côté opposé à la face 201. Dans cet exemple où la cavité 204 se prolonge par la cavité 210, l'anneau 214 est disposé à la jonction entre les cavités 204 et 210. L'anneau 214 a un diamètre interne supérieur au diamètre (externe) du guide d'onde 202 et inférieur au diamètre (externe) de la gaine 208, de sorte que seule une portion du guide d'onde 202 non revêtue de la gaine 208 peut passer à travers l'anneau 214 et que la gaine 208 vient en butée contre l'anneau 214, comme cela est illustrée notamment par la figure 2D.

A titre d'exemple, l'anneau 214 est maintenu mécaniquement en place dans le boîtier 200 par une rigole ou nervure formée dans le boîtier 200, dans laquelle s'insère la périphérie de l'anneau 214 (figure 2D). Selon un autre exemple non illustré, l'anneau 214 correspond à une portion du boîtier 200, l'anneau 214 et le boîtier 200 étant d'une seule pièce, par exemple en prévoyant que la partie 200A du boîtier comprenne une partie de l'anneau 214 et que la partie 200B du boîtier comprenne l'autre partie de l'anneau 214.

A titre d'exemple, l'anneau 214 est en le même matériau que le boitier ou en le même matériau que le guide d'onde 202.

Du fait que la gaine 208 du guide d'onde 202 n'est pas présente dans la cavité 204 où s'effectue le couplage entre l'antenne 108 et le guide d'onde 202 dans une configuration de transmission filaire, elle ne perturbe pas ce couplage. La personne du métier est en mesure de choisir la distance entre la face 201 et le dispositif de butée de la gaine, par exemple l'anneau 214, de manière que le dispositif de butée et la gaine 208 ne perturbent pas le couplage entre l'antenne 108 et le guide d'onde 202.

Le boîtier 200 comprend des éléments 216 de fixation configurés pour permettre une fixation amovible de la partie 20 du connecteur 1 à la partie 10 du connecteur 1 (figures 1A à 1C). Ces éléments de fixation 216 sont par exemple destinés à coopérer avec des éléments de fixation amovible correspondants 116 de la partie 10 du connecteur 1.

Dans l'exemple représenté, le boîtier 202 comprend des aimants 216 du côté de la face 201, les aimants 216 affleurant par exemple la face 201. Dans un autre exemple non illustré, le boîtier 200 comprend des trous traversants le boîtier 200 orthogonalement à la face 201, de manière à y insérer des vis pour pouvoir fixer de manière amovible les deux parties du connecteur 1 entre elles. La personne du métier est en mesure de mettre en œuvre d'autres moyens connus de fixation amovible.

Bien entendu, dans cet exemple où les parties 10 et 20 du connecteur 1 sont destinées à être attachées l'une à l'autre de manière amovible par les aimants 116 et 216, chaque aimant 216 est disposé dans le boîtier 200 de manière à coopérer avec un aimant 116 correspondant du boitier 102 (figures 1A à 1C).

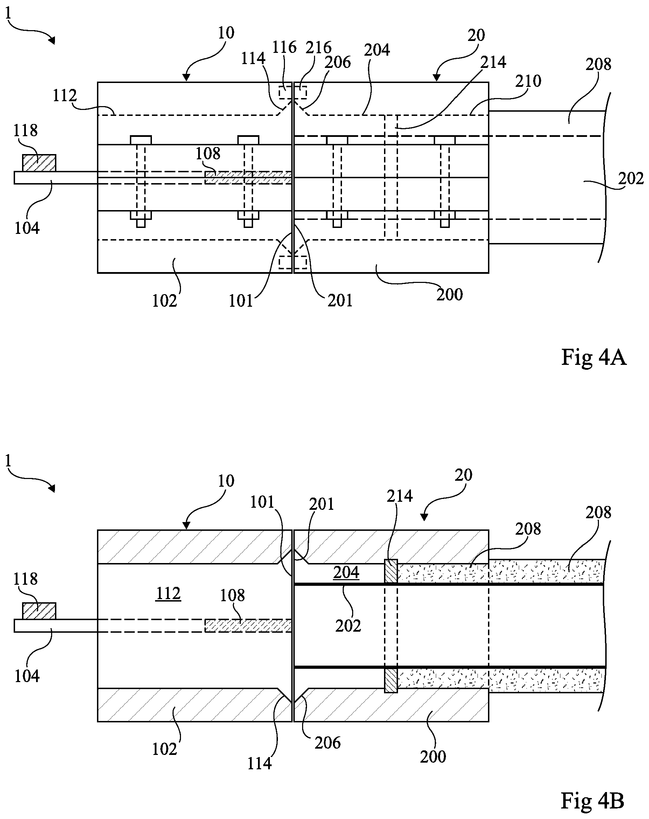

Les figures 4A et 4B illustrent le connecteur 1 décrit précédemment lorsque la partie amovible 20 du connecteur 1 est attachée de manière amovible à la partie 10 du connecteur 1, c'est-à-dire quand le connecteur est dans une configuration de transmission filaire. Plus particulièrement, la figure 4A est une vue de côté du connecteur 1, correspondant aux vues des figures 1A et 2A, la figure 4B étant une vue en coupe prise dans le plan DD de la figure 2B.

Bien que cela n'ait pas été indiqué précédemment, le diamètre de la cavité 112 au niveau de la face 101 et le diamètre de la cavité 204 au niveau de la face 201 sont de préférence sensiblement égaux, par exemple égaux.

En outre, les parties 10 et 20 du connecteur 1, notamment leurs éléments de fixation respectifs 116 et 216, sont configurées, lorsqu'elles sont fixées ensemble de manière amovible, pour que les faces 101 et 201 soient en contact et que les cavités 112 et 204 soient mises bout à bout. Lorsqu'elles sont mises bout à bout, la direction longitudinale de la cavité 112 est alignée avec celle de la cavité 204.

Dit autrement, lorsque les deux parties 10 et 20 du connecteur 1 sont fixées l'une à l'autre de manière amovible, les cavités 112 et 204 forment une cavité d'air à section transversale circulaire dans laquelle est disposée la région de couplage entre l'antenne 108 et le guide d'onde 202.

Du fait que chacune des cavités 112 et 204 a une paroi bloquant les ondes radiofréquences, la cavité formée par les cavités 112 et 204 mises bout à bout est également configurée pour bloquer les ondes radiofréquences provenant de l'extérieur du connecteur 1, ce qui permet de ne pas perturber le couplage entre l'antenne 108 et le guide d'onde 202.

Par ailleurs, dans un mode de réalisation où le diamètre de la cavité 112, respectivement 204, augmente en direction de la face 101, respectivement 201, le diamètre de la cavité d'air formée par l'ensemble des cavités 112 et 204 mises bout à bout est plus grand au niveau de zone de couplage de l'antenne 108 au guide d'onde 202. Cela permet de limiter, voir supprimer, l'influence des boîtiers 102 et 200, par exemple des parois métalliques de leurs cavités respectives 112 et 204, sur ce couplage.

En outre, du fait que la direction longitudinale de la cavité 112 est alignée avec la direction d'émission de l'antenne 108, et que la direction longitudinale de la cavité 204 est alignée avec la direction longitudinale de l'extrémité du guide d'onde 202, lorsque les parties 10 et 20 du connecteur 1 sont attachées l'une à l'autre de manière amovible, la direction d'émission de l'antenne 108 est autoalignée avec la direction longitudinale de l'extrémité du guide d'onde 202, ce qui permet le couplage de l'antenne 108 avec le guide d'onde 202.

Bien que cela ne soit pas visible en figures 4A et 4B, comme le bord de la carte 104 est, de préférence, en léger retrait par rapport à la face 101 de la partie 10 du connecteur 1 et/ou que l'extrémité du guide d'onde 202 est, de préférence, en léger retrait par rapport à la face 201 de la partie 20 du connecteur 1, il y a un espace, par exemple inférieur à un millimètre, entre la carte 104 et l'extrémité du guide d'onde 202. La valeur de cet espace peut être adaptée par la personne du métier en fonction de performances de couplage visées entre l'antenne 108 et le guide d'onde 202. De préférence, la carte 104 et le guide d'onde 202 ne sont pas en contact.

Le connecteur 1 décrit précédemment en relation avec les figures 1A à 1C, 2A à 2D, 3 et 4A et 4B permet donc de mettre en œuvre une transmission radiofréquence filaire lorsque la partie 20 du connecteur 1 est attachée de manière amovible à la partie 10 du connecteur 1, et une transmission radiofréquence sans fil lorsque la partie 20 du connecteur 1 n'est pas attachée à la partie 10 du connecteur, sans qu'il soit nécessaire de modifier la puce 118, la carte 104 et le boîtier 102.

En particulier, par rapport au connecteur présenté dans l'article "An 18Gbps Polymer Microwave Fiber (PMF) Communication Link in 40nm CMOS" mentionné précédemment, le connecteur 1 permet une transmission radiofréquence sans fil. On pourrait penser que retirer le guide d'onde du boîtier du connecteur de cet article aurait suffit à rendre ce connecteur compatible avec une transmission sans fil. Toutefois, le boîtier aurait probablement perturbé l'émission du coupleur à fente conique qui n'aurait pas émis un champ aussi puissant que ce que permet le connecteur 1 décrit précédemment. En outre, le connecteur de l'article susmentionné ne permettrait pas une transmission radiofréquence sans fil respectant les normes en vigueur dans certaines bandes de fréquences comme par exemple la bande de fréquence à 60 GHz, ce que permet le connecteur 1 muni du filtre couplant l'antenne 108 et la puce 118. On aurait également pu penser que retirer le guide d'onde et le boitier du connecteur de cet article aurait suffi à le rendre compatible avec une transmission sans fil. Toutefois, le gain d'antenne du connecteur n'aurait pas été aussi élevée que le gain d'antenne du connecteur 1 du fait que, dans le connecteur 1, le boîtier 102 participe à la directivité d'émission de l'antenne 108 et à l'augmentation de son gain.

En outre, le connecteur 1 permet de maintenir le guide d'onde 202 solidaire du boîtier 200, ce qui n'est pas le cas du connecteur décrit dans l'article susmentionné où le guide d'onde est juste inséré dans le boîtier, sans qu'il ne soit mentionné de dispositif spécifique permettant de fixer le guide d'onde de manière solidaire au boîtier.

A titre d'exemple, les inventeurs ont réalisé un connecteur 1 configuré pour une transmission radiofréquence à 60 GHz. Le connecteur 1 réalisé respecte les contraintes de la spécification ETSI EN 305550 pour une configuration de transmission sans fil. Le connecteur 1 réalisé est configuré pour une utilisation avec un guide d'onde tel que décrit dans la demande de brevet WO 2017191409 pour une configuration de transmission filaire. Pour cet exemple de réalisation, la carte 104 a, par exemple, une largeur (prise dans la direction d'émission 110 de l'antenne 108) de l'ordre de 16 mm et une longueur de l'ordre de 30 mm. En outre, pour cet exemple de réalisation, l'antenne 108 est une antenne ALTSA occupant une surface de l'ordre de 10 mm*10 mm, par exemple une surface de 6,5 mm*5, 7 mm. Pour cet exemple de réalisation, les inventeurs ont constaté que le connecteur 1 conduisait à un coefficient de transmission entre la puce 118 et le guide d'onde 202 supérieur à -2,5 dB et à des réflexions entre la puce 118 et la ligne de transmission sur laquelle elle est montée inférieure à -10 dB.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En particulier, on a décrit une ligne de transmission de la carte 104 comprenant une portion mise en œuvre par un guide d'onde SIW, dans lequel peut être intégré un filtre passe bande. Cette portion de guide d'onde SIW éventuellement muni du filtre passe bande peut être remplacée par une portion de guide d'onde rempli d'air intégré au substrat ("Air Filled Substrate Integrated Waveguide") ou AFSIW, éventuellement muni du filtre passe bande intégré au guide d'onde AFSIW.

En outre, bien que l'on ait décrit des exemples de modes de réalisation dans lesquels l'antenne 108 est configurée pour émettre dans une direction 110 parallèle à la carte 104, l'antenne 108, par exemple une antenne patch, peut être configurée pour émettre dans une direction orthogonale à la carte 104. La personne du métier est en mesure d'adapter la description faite ci-dessus à une antenne 108 émettant orthogonalement à la carte 104, par exemple en prévoyant que la direction longitudinale de la cavité 112 soit orthogonale à la carte 104 et que la face 101 du boîtier soit alors la face supérieure du boîtier.

De plus, bien que l'on ait décrit et illustré une cavité 112 traversant le boîtier 102 de part en part, on peut prévoir que la cavité 112 soit fermée du côté opposé à la face 101, par exemple en prévoyant que la cavité 101 ait une forme conique du côté opposé à la face 101.

On a décrit des modes de réalisation dans lesquels la cavité 204 du boîtier 200 se prolonge par une cavité 210 destinée à accueillir une portion du guide d'onde 202 revêtu de la gaine 208, et dans lequel un anneau 214 de butée pour la gaine 208 est disposé entre les cavités 204 et 210. On peut omettre la cavité 210 en prévoyant, par exemple, que la face de l'anneau 214 opposée à la cavité 204 affleure une face du boîtier 200 opposée à la face 201, et que cette face du boitier comprenne des crochets ou des plots ou un dispositif mécanique venant faire pression sur la gaine 208 lorsque l'extrémité du guide d'onde 202 dépourvue de gaine 208 est insérée dans la cavité 204 et que la gaine 208 vient en butée contre l'anneau 214.

La personne du métier est également en mesure de modifier la fréquence de fonctionnement du connecteur 1, c'est-à-dire la fréquence du champ radiofréquence transportant la majorité de la puissance émise par l'antenne 108, par exemple en modifiant la fréquence centrale du filtre et/ou en modifiant les dimensions et la forme de l'antenne 108.

De plus, le connecteur 1 décrit ci-dessus n'est pas limité à une utilisation avec un guide d'onde diélectrique, ou guide d'onde plastique, du type décrit dans la demande WO 2017191409 précédemment mentionnée, et peut être utilisé avec tout type de guide d'onde radiofréquence diélectrique à section transversale circulaire.

Enfin, la mise en oeuvre pratique des modes de réalisation et variantes décrits est à la portée de la personne du métier à partir des indications fonctionnelles données ci-dessus. En particulier, la personne du métier est en mesure de choisir les diamètres des cavités 112, 204 et éventuellement 210 en fonction de l'application visée (diamètre du guide d'onde 202, diamètre de la gaine 208, type d'antenne 108, fréquence de fonctionnement, etc.), par exemple en s'appuyant sur un outil de simulation assisté par ordinateur tel que le logiciel désigné par l'appellation commerciale Ansys HFSS. Plus généralement, la personne du métier est en mesure d'adapter la forme et/ou les dimensions des boîtiers 102 et 200 en fonction de l'application visée.

## Revendications

1. Connecteur mécaniquement configurable entre une transmission radiofréquence sans fil et une transmission radiofréquence filaire via un guide d'onde diélectrique radiofréquence cylindrique (202), le connecteur (1) comportant :
- un premier boîtier (102) assemblé avec une carte de circuit imprimé (104) munie d'une antenne radiofréquence (108) ; et
- un deuxième boîtier (200) configuré pour être assemblé avec le guide d'onde (202),
dans lequel :
le deuxième boîtier (200) est configuré pour être monté de manière amovible au premier boîtier (102) dans une configuration de transmission filaire et est détaché du premier boîtier (102) dans une configuration de transmission sans fil ;
le premier boîtier (102) comprend une première cavité (112) de section transversale circulaire autour de l'antenne (108), la première cavité (112) débouchant sur une première face (101) du premier boîtier (102) et ayant une paroi en un matériau configuré pour bloquer les ondes radiofréquences ;
le deuxième boîtier (200) comprend une deuxième cavité (204) de section transversale circulaire autour d'une extrémité du guide d'onde (202) lorsque le guide d'onde est assemblé avec le deuxième boîtier, la deuxième cavité (204) débouchant sur une deuxième face (201) du deuxième boîtier (200) et ayant une paroi en un matériau configuré pour bloquer les ondes radiofréquences ;
les première (101) et deuxième (201) faces sont configurées pour être en contact et les première (112) et deuxième (204) cavités sont configurées pour être mises bout à bout dans une configuration de transmission filaire ;
les première (112) et deuxième (204) cavités mises bout à bout définissent une troisième cavité, une zone de couplage de l'antenne (108) au guide d'onde (202) étant disposée dans ladite troisième cavité ; et
la première cavité (112) comprend un chanfrein (114) du côté de la première face (101) et la deuxième cavité (204) comprend un chanfrein (206) correspondant du côté de la deuxième face (201).

2. Connecteur selon la revendication 1, dans lequel un diamètre de la troisième cavité est plus grand au niveau de ladite zone de couplage.

3. Connecteur selon la revendication 1 ou 2, dans lequel la première cavité (112) est alignée longitudinalement avec une direction d'émission (110) de l'antenne (108) et la deuxième cavité (204) est alignée longitudinalement avec l'extrémité du guide d'onde (202) lorsque le guide d'onde et le deuxième boîtier (200) sont assemblés, la deuxième cavité (204) étant alignée longitudinalement avec la première cavité (112) lorsque le deuxième boîtier (200) est fixé de manière amovible au premier boîtier (102).

4. Connecteur selon l'une quelconque des revendications 1 à 3, dans lequel le guide d'onde (202) est entouré d'une gaine en mousse (208) en amont de ladite extrémité, le deuxième boîtier (200) étant configuré pour enserrer la gaine (208) du guide d'onde (202) en exerçant une pression sur la gaine (208) lorsque le guide d'onde (202) et le deuxième boîtier (200) sont assemblés, l'extrémité du guide d'onde (202) étant dépourvue de gaine (208) dans la deuxième cavité (204).

5. Connecteur selon la revendication 4, dans lequel le deuxième boîtier (200) comprend, du côté de la deuxième cavité (204) opposée à la deuxième face (201), un anneau (214) dont le diamètre interne est supérieur au diamètre du guide d'onde (202) et inférieur au diamètre de ladite gaine (208), le deuxième boîtier (200) étant configuré pour que la gaine (208) soit en butée contre l'anneau (214) lorsque le guide d'onde (202) et le deuxième boîtier (200) sont assemblés.

6. Connecteur selon l'une quelconque des revendications 1 à 5, dans lequel le deuxième boîtier (200) est configuré pour que l'extrémité du guide d'onde (202) affleure la deuxième face (201), ou soit en retrait de moins d'un millimètre par rapport à la deuxième face (201), lorsque le guide d'onde (202) et le deuxième boîtier (200) sont assemblés.

7. Connecteur selon l'une quelconque des revendications 1 à 6, dans lequel le deuxième boîtier (200) comprend deux parties (200A, 200B) fixées l'une à l'autre, chacune des deux parties définissant une partie de la deuxième cavité (210), un plan de contact entre lesdites deux parties (200A, 200B) étant parallèle à une direction longitudinale de la deuxième cavité.

8. Connecteur selon l'une quelconque des revendications 1 à 7, dans lequel l'antenne (108) est entièrement disposée dans la première cavité (112).

9. Connecteur selon l'une quelconque des revendications 1 à 8, dans lequel une puce de circuit intégré (118) configuré pour recevoir un signal radiofréquence de l'antenne et/ou pour fournir un signal radiofréquence à l'antenne (108) est destinée à être montée sur la carte de circuit imprimé (104), et une ligne de transmission radiofréquence de la carte de circuit imprimé (104) est configurée pour coupler la puce (118) montée sur la carte (104) à l'antenne (108).

10. Connecteur selon la revendication 9, dans lequel la ligne de transmission comprend un filtre radiofréquence passe-bande couplant la puce (118) à l'antenne (108), le filtre étant de préférence un filtre intégré au substrat de la carte de circuit imprimé, ou un filtre rempli d'air intégré au substrat de la carte de circuit imprimé.

11. Connecteur selon l'une quelconque des revendications 1 à 10, dans lequel les premier (102) et deuxième (200) boîtiers sont configurés pour bloquer des ondes radiofréquences, les premier et deuxième boîtiers étant par exemple en un métal tel que de l'aluminium, en un alliage métallique tel qu'un alliage métallique comprenant de l'aluminium, en un plastique revêtu d'un métal tel que de l'aluminium, ou en un plastique revêtu d'un alliage métallique tel qu'un alliage métallique comprenant de l'aluminium.

12. Connecteur selon l'une quelconque des revendications 1 à 11, configuré pour des transmissions radiofréquences à 60 GHz.

## Patentansprüche

1. Ein Verbinder, der mechanisch zwischen einer drahtlosen Hochfrequenzübertragung und einer drahtgebundenen Hochfrequenzübertragung über einen zylindrischen dielektrischen Hochfrequenzwellenleiter (202) konfigurierbar ist,
wobei der Verbinder (1) Folgendes aufweist:
- ein erstes Gehäuse (102), das mit einer Leiterplatte (104) zusammengebaut ist, die mit einer Hochfrequenzantenne (108) versehen ist; und
- ein zweites Gehäuse (200), das eingerichtet zum Zusammenbauen mit dem Wellenleiter (202) ist,
wobei:
das zweite Gehäuse (200) eingerichtet zum lösbaren Zusammenbauen mit dem ersten Gehäuse (102) in einer drahtgebundenen Übertragungskonfiguration ist und von dem ersten Gehäuse (102) in einer drahtlosen Übertragungskonfiguration getrennt ist;
das erste Gehäuse (102) einen ersten Hohlraum (112) aufweist, der einen kreisförmigen Querschnitt quer zu der Antenne (108) aufweist, wobei der erste Hohlraum (112) an einer ersten Oberfläche (101) des ersten Gehäuses (102) mündet und eine Wand aus einem Material aufweist, das eingerichtet zum Blockieren von Hochfrequenzwellen ist;
das zweite Gehäuse (200) einen zweiten Hohlraum (204) aufweist, der einen kreisförmigen Querschnitt quer zu einem Ende des Wellenleiters (202) aufweist, wenn der Wellenleiter mit dem zweiten Gehäuse zusammengebaut ist, wobei der zweite Hohlraum (204) an einer zweiten Oberfläche (201) des zweiten Gehäuses (200) mündet und eine Wand aus einem Material aufweist, das eingerichtet zum Blockieren von Hochfrequenzwellen ist;
die erste (101) und die zweite (201) Oberfläche eingerichtet sind, miteinander in Kontakt zu sein, und der erste (112) und der zweite (204) Hohlraum eingerichtet sind, Ende an Ende in einer drahtgebundenen Übertragungskonfiguration angeordnet zu sein;
der erste (112) und der zweite (204) Hohlraum, die Ende an Ende angeordnet sind, einen dritten Hohlraum definieren, wobei ein Kopplungsbereich der Antenne (108) mit dem Wellenleiter (202) in dem genannten dritten Hohlraum angeordnet ist; und
der erste Hohlraum (112) eine Fase (114) auf der Seite der ersten Oberfläche (101) aufweist und der zweite Hohlraum (204) eine entsprechende Fase (206) auf der Seite der zweiten Oberfläche (201) aufweist.

2. Der Verbinder nach Anspruch 1, wobei ein Durchmesser des dritten Hohlraums auf Höhe des genannten Kopplungsbereichs größer ist.

3. Der Verbinder nach Anspruch 1 oder 2, wobei der erste Hohlraum (112) längs einer Emissionsrichtung (110) der Antenne (108) ausgerichtet ist und der zweite Hohlraum (204) längs des Endes des Wellenleiters (202) ausgerichtet ist, wenn der Wellenleiter und das zweite Gehäuse (200) zusammengebaut sind, wobei der zweite Hohlraum (204) längs des ersten Hohlraums (112) ausgerichtet ist, wenn das zweite Gehäuse (200) lösbar mit dem ersten Gehäuse (102) zusammengebaut ist.

4. Der Verbinder nach einem der Ansprüche 1 bis 3, wobei der Wellenleiter (202) vor dem genannten Ende von einer Schaumstoffummantelung (208) umgeben ist, wobei das zweite Gehäuse (200) eingerichtet zum dichten Umgeben der Ummantelung (208) des Wellenleiters (202) unter Ausüben eines Drucks auf die Ummantelung (208) ist, wenn der Wellenleiter (202) und das zweite Gehäuse (200) zusammengebaut sind, wobei das Ende des Wellenleiters (202) in dem zweiten Hohlraum (204) keine Ummantelung (208) aufweist.

5. Der Verbinder nach Anspruch 4, wobei das zweite Gehäuse (200) auf der Seite des zweiten Hohlraums (204), die der zweiten Oberfläche (201) gegenüberliegt, einen Ring (214) hat, der einen Innendurchmesser aufweist, der größer als der Durchmesser des Wellenleiters (202) und kleiner als der Durchmesser der genannten Ummantelung (208) ist, wobei das zweite Gehäuse (200) so eingerichtet ist, dass die Ummantelung (208) gegen den Ring (214) stößt, wenn der Wellenleiter (202) und das zweite Gehäuse (200) zusammengebaut sind.

6. Der Verbinder nach einem der Ansprüche 1 bis 5, wobei das zweite Gehäuse (200) so eingerichtet ist, dass das Ende des Wellenleiters (202) bündig mit der zweiten Oberfläche (201) ist oder in Bezug auf die zweite Oberfläche (201) um weniger als einen Millimeter zurückversetzt ist, wenn der Wellenleiter (202) und das zweite Gehäuse (200) zusammengebaut sind.

7. Der Verbinder nach einem der Ansprüche 1 bis 6, wobei das zweite Gehäuse (200) zwei miteinander befestigte Abschnitte (200A, 200B) aufweist, wobei jeder der zwei Abschnitte einen Teil des zweiten Hohlraums (210) definiert und wobei eine Kontaktfläche zwischen den genannten zwei Abschnitten (200A, 200B) parallel zu einer Längsrichtung des zweiten Hohlraums verläuft.

8. Der Verbinder nach einem der Ansprüche 1 bis 7, wobei die Antenne (108) vollständig innerhalb des ersten Hohlraums (112) angeordnet ist.

9. Der Verbinder nach einem der Ansprüche 1 bis 8, wobei ein integrierter Schaltkreischip (118), der eingerichtet zum Empfangen eines Hochfrequenzsignals der Antenne und/oder zum Liefern eines Hochfrequenzsignals an die Antenne (108) ist, dazu bestimmt ist, auf der Leiterplatte (104) zusammengebaut zu werden, und eine Hochfrequenzübertragungsleitung der Leiterplatte (104) eingerichtet ist, den Chip (118), der auf der Leiterplatte (104) zusammengebaut ist, mit der Antenne (108) zu koppeln.

10. Der Verbinder nach Anspruch 9, wobei die Übertragungsleitung einen Hochfrequenz-Bandpassfilter aufweist, der den Chip (118) mit der Antenne (108) koppelt, wobei der Filter vorzugsweise ein in das Substrat der Leiterplatte integrierter Filter oder ein mit Luft gefüllter, in das Substrat der Leiterplatte integrierter Filter ist.

11. Der Verbinder nach einem der Ansprüche 1 bis 10, wobei das erste (102) und das zweite (200) Gehäuse eingerichtet zum Blockieren von Hochfrequenzwellen sind, wobei das erste und das zweite Gehäuse beispielsweise hergestellt sind aus einem Metall wie Aluminium, aus einer Metalllegierung wie einer Aluminium enthaltenden Metalllegierung, aus mit einem Metall wie Aluminium beschichtetem Kunststoff oder aus mit einer Metalllegierung wie einer Aluminium enthaltenden Metalllegierung beschichtetem Kunststoff.

12. Der Verbinder nach einem der Ansprüche 1 bis 11, eingerichtet für Hochfrequenzübertragungen bei 60 GHz.

## Claims

1. Connector mechanically configurable between a wireless radio frequency transmission and a wired radio frequency transmission via a cylindrical dielectric radio frequency waveguide (202), the connector (1) comprising:
- a first package (102) assembled to a printed circuit board (104) provided with a radio frequency antenna (108); and
- a second package (200) configured to be assembled to the waveguide (202),
wherein:
the second package (200) is configured to be removably assembled to the first package (102) in a wired transmission configuration and is separated from the first package (102) in a wireless transmission configuration;
the first package (102) comprises a first cavity (112) having a circular transverse cross-section around the antenna (108), the first cavity (112) emerging onto a first surface (101) of the first package (102) and having a wall made of a material configured to block radio frequency waves;
the second package (200) comprises a second cavity (204) having a circular transverse cross-section around an end of the waveguide (202) when the waveguide is assembled to the second package, the second cavity (204) emerging onto a second surface (201) of the second package (200) and having a wall made of a material configured to block radio frequency waves;
the first (101) and second (201) surfaces are configured to be in contact and the first (112) and second (204) cavities are configured to be placed end-to-end in a wired transmission configuration;
the first (112) and second (204) cavities placed end-to-end define a third cavity, an area of coupling of the antenna (108) to the waveguide (202) being arranged in said third cavity; and
the first cavity (112) comprises a chamfer (114) on the side of the first surface (101) and the second cavity (204) comprises a corresponding chamfer (206) on the side of the second surface (201).

2. Connector according to claim 1, wherein a diameter of the third cavity is larger at the level of said coupling area.

3. Connector according to claim 1 or 2, wherein the first cavity (112) is longitudinally aligned with an emission direction (110) of the antenna (108) and the second cavity (204) is longitudinally aligned with the end of the waveguide (202) when the waveguide and the second package (200) are assembled, the second cavity (204) being longitudinally aligned with the first cavity (112) when the second package (200) is removably assembled to the first package (102).

4. Connector according to any of claims 1 to 3 wherein the waveguide (202) is surrounded with a foam sheath (208) upstream of said end, the second package (200) being configured to tightly encircle the sheath (208) of the waveguide (202) while exerting a pressure on the sheath (208) when the waveguide (202) and the second package (200) are assembled, the end of the waveguide (202) comprising no sheath (208) in the second cavity (204).

5. Connector according to claim 4, wherein the second package (200) comprises, on the side of the second cavity (204) opposite to the second surface (201), a ring (214) having an inner diameter greater than the diameter of the waveguide (202) and smaller than the diameter of said sheath (208), the second package (200) being configured so that the sheath (208) abuts against the ring (214) when the waveguide (202) and the second package (200) are assembled.

6. Connector according to any of claims 1 to 5, wherein the second package (200) is configured so that the end of the waveguide (202) is flush with the second surface (201), or is recessed by less than one millimeter with respect to the second surface (201), when the waveguide (202) and the second package (200) are assembled.

7. Connector according to any of claims 1 to 6, wherein the second package (200) comprises two portions (200A, 200B) fastened to each other, each of the two portions defining a portion of the second cavity (210), a contact plane between said two portions (200A, 200B) being parallel to a longitudinal direction of the second cavity

8. Connector according to any of claims 1 to 7, wherein the antenna (108) is entirely arranged inside of the first cavity (112).

9. Connector according to any of claims 1 to 8, wherein an integrated circuit chip (118) configured to receive a radio frequency signal of the antenna and/or to deliver a radio frequency signal to the antenna (108) is intended to be assembled on the printed circuit board (104), and a radio frequency transmission line of the printed circuit board (104) is configured to couple the chip (118) assembled on the board (104) to the antenna (108).

10. Connector according to claim 9, wherein the transmission line comprises a bandpass radio frequency filter coupling the chip (118) to the antenna (108), the filter preferably being a filter integrated to the substrate of the printed circuit board, or a filter filled with air integrated to the substrate of the printed circuit board.

11. Connector according to any of claims 1 to 10, wherein the first (102) and second (200) packages are configured to block radio frequency waves, the first and second packages for example being made of a metal such as aluminum, of a metal alloy such as a metal alloy comprising aluminum, of plastic coated with a metal such as aluminum, or of plastic coated with a metal alloy such as a metal alloy comprising aluminum.

12. Connector according to any of claims 1 to 11, configured for radio frequency transmissions at 60 GHz.
